# EUROPEAN PATENT SPECIFICATION

(11) **EP 1 877 870 B1**
(45) Date of publication and mention of the grant of the patent: **16.02.2011**
(21) Application number: 06738451.1
(22) Date of filing: 16.03.2006
(51) Int. Cl.: G03F 7/42, C11D 3/37, C11D 11/00

(54) **NON-AQUEOUS PHOTORESIST STRIPPER THAT INHIBITS GALVANIC CORROSION**
WASSERFREIE PHOTOLACKÄTZLÖSUNG, WELCHE DIE GALVANISCHE KORROSION VERHINDERT
DECAPANT PHOTORESISTANT NON AQUEUX EMPECHANT LA CORROSION GALVANIQUE

(30) Priority: 19.04.2005 US 672923 P
(43) Date of publication of application: 16.01.2008
(73) Proprietor: Avantor Performance Materials, Inc., Phillipsburg NJ 08865 (US)
(72) Inventor: INAOKA, Seiji, Nazareth, Pennsylvania 18064 (US)
(74) Representative: Cockerton, Bruce Roger
(86) International application number: PCT/US2006/009389
(87) International publication number: WO 2006/112994

(56) References cited:
- EP-A- 1 128 221
- EP-A- 1 150 172
- EP-A- 1 178 359
- WO-A-03/104185
- WO-A-2006/019402
- WO-A-2006/023061
- WO-A-2006/062534
- WO-A-2006/065256
- US-A- 5 612 304
- US-B1- 6 218 087

## Description

### FIELD OF THE INVENTION

This invention relates to methods and non-aqueous, essentially non-corrosive, cleaning compositions for cleaning microelectronic substrates, and particularly to such cleaning compositions useful with and having improved compatibility with microelectronic substrates charaterized by stacked layer structures of different types of metals at a surface on the microelectronic substrate, and the invention also relates to the use of such cleaning compositions for stripping photoresists, and cleaning residues from etch and plasma process generated organic, organometallic and inorganic compounds.

### BACKGROUND TO THE INVENTION

Many photoresist strippers and residue removers have been proposed for use in the microelectronics field as downstream or back end of the manufacturing-line cleaners. In the manufacturing process a thin film of photoresist is deposited on a wafer substrate, and then circuit design is imaged on the thin film. Following baking, the unpolymerized resist is removed with a photoresist developer. The resulting image is then transferred to the underlying material, which is generally a dielectric or metal, by way of reactive plasma etch gases or chemical etchant solutions. The etch gases or chemical etchant solutions selectively attack the photoresist-unprotected area of the substrate.

Additionally, following the termination of the etching step, the resist mask must be removed from the protected area of the wafer so that the final finishing operation can take place. This can be accomplished in a plasma ashing step by the use of suitable plasma ashing gases or wet chemical strippers. Finding a suitable cleaning composition for removal of this resist mask material without adversely affecting, e.g., corroding, dissolving or dulling, the metal circuitry has also proven problematic.

As microelectronic fabrication integration levels have increased and patterned microelectonic device dimensions have decreased towards the size of atoms, it is often times beneficial to adopt a layered structure of different types of metals as a conductor in order to, among other things, provide additional mechanical strength to the conductor line structure in the microelectronic device. For example, aluminum is often used with additional layers of other metals, such as for example, copper, chromium or molybdenum. Although type of metal is changed in the construction of the device, many of other process conditions remain essentially the same, including photoresist with similar molecular structure that is used to make a circuit by patterning the surface prior to metal etch. Photoresist stripper often contains amine compounds that show superior performance to attack hardened photoresist and eventually strip photoresist from the metal surface. However, metal is also severely attacked by amines, and furthermore, if the above-mentioned layered metal structure Is processed in the conventionally used photoresist cleaners/strippers as well as subsequent rinsing processes with water involvement, significant corrosion occurs. This significant corrosion generally occurs according to the following mechanism. Galvanic potential forms between different type of metals when they are electrically contact, the electrons move from one metal (that has higher tendency of ionization) to another metal (with lower ionization tendency), the former metal is ionized, dissolve into a solution, and as a result, severely corroded.

For example, the addition of copper, to aluminum layers, although resulting in electromigration resistance improvements, increased the risk of specific type of corrosion mechanisms, of the Al--Cu alloy, compared to the risk of corrosion encountered with pure aluminum layers. For example during the deposition of Al--Cu alloy, a theta phase of Al₂Cu precipitates are formed, highly rich in copper, and surrounded by regions of aluminum, that have almost been completely depleted of copper. This Inhomogeneity, in the aluminum based layer, can result in a galvanic cell in which the Al₂Cu precipitates behave as the cathode, while the surrounding aluminum rich regions behave as the anode. Therefore the presence of an electrolyte can then result in galvanic corrosion, or a redox reaction, in which Al will be oxidized, while the Cu is reduced. The Al³⁺ ions produced during this reaction, can be leached away during subsequent water rinses. Since this galvanic reaction is localized near the Al₂Cu precipitates, the result of this galvanic reaction is the formation of voids in the aluminum layer. The aluminum based layer, containing voids, is now less resistant to deleterious electromigration phenomena, as well as exhibiting a decrease in conductivity.

Removal of etch and/or ash residues following the plasma etch and/or ashing process for such molybdenum, copper and aluminum metalllized microelectronic structures has proved problematic. Failure to completely remove or neutralize these residues can result in the absorption of moisture and the formation of undesirable materials that can cause the afore-mentioned corrosion to the metal structures. The circuitry materials are corroded by the undesirable materials and produce discontinuances in the circuitry wiring and undesirable increases in electrical resistance.

WO 03104185 discloses a residue remover for removing polymeric material and etch residue includes 2-(2-aminoethylamino)-ethanol and optionally another two-carbon atom linkage alkanolamine compound, gallic acid or catechol, water, a polar organic solvent, and hydroxylamine.

Therefore, it is highly desirable to provide formulations as photoresist strippers that provide good stripping performance for removing photoresist as well as etching and ashing residues that has good inhibition performance for galvanic corrosion when used on stacked layer structures of different types of metals at a surface of an electronic device.

### BRIEF SUMMARY OF THE INVENTION

Back end photoresist strippers and cleaning compositions of this invention are provided by non-aqueous, non-corrosive cleaning compositions that resist galvanic corrosion when used on stacked layer structures of different types of metals at a surface of an electronic device. Such non-aqueous photoresist strippers and cleaning compositions are as defined in claim 1.

The compositions of this Invention may also contain a number of other optional components. The cleaning compositions of this invention can be used over a wide range of process/operating conditions of pH and temperature, and can be used to effectively remove photoresists, post plasma etch/ash residues, sacrificial light absorbing materials and anti-reflective coatings (ARC) and hardened photoresists.

The non-aqueous, essentially non-corrosive microelectronic stripper/cleaner compositions of this invention comprises from 50 to 90 wt % of the organic polar solvent component, from 5% to 20% of the di- or poly-amine component, and a corrosion-inhibiting amount of the corrosion inhibitor polymer component, and from 0.1% to 10% of the corrosion inhibitor component. The wt percentages provided in this specification are based on the total weight of the stripping and cleaning composition.

The non-aqueous, essentially non-corrosive stripping/cleaning compositions of this invention can also optionally contain other compatible components, including but not limited to components such as chelating agents, organic hydroxyl-containing co-solvents, stabilizing and metal chelating or complexing agents, and surfactants.

### DETAILED DESCRIPTION OF INVENTION AND PREFERRED EMBODIMENTS

Back end photoresist strippers and cleaning compositions of this invention are provided by non-aqueous, non-corrosive cleaning compositions that resist galvanic corrosion when used on stacked layer structures of different types of metals at a surface of an electronic device. Such non-aqueous photoresist strippers and cleaning compositions are defined in claim 1.
By "non-aqueous" it is meant that the compositions are substantially free of water and will generally only have water present as impurities from the other components, and then will generally amount to no more than about 3% by weight of the composition, and preferably less.

The cleaning compositions of this invention can be used over a wide range of process/operating conditions of pH and temperature, and can be used to effectively remove photoresists, post plasma etch/ash residues, sacrificial light absorbing materials and anti-reflective coatings (ARC). Additionally, very difficult to clean samples, such as highly crosslinked or hardened photoresists are readily cleaned by the compositions of this invention.

The non-aqueous, essentially non-corrosive microelectronic stripper/cleaner compositions of this invention comprises from 50 to 90 wt%, preferably from 85 to 90 wt%, and most preferably about 90 wt%, of the organic polar solvent component; from 5% to 20 wt%, preferably from 5 to 15 wt%, and more preferably from 10% to 15 wt%, of the organic di- or polyamine component, and a corrosion-inhibiting amount of the corrosion inhibitor polymer component, from 0.1 to 10 wt%, preferably from 0.3% to 5 wt%, and more preferably from 0.3% to 3%, and even more preferably about 1 wt%. The wt percentages provided in this specification are based on the total weight of the cleaning composition.

The compositions of this invention can contain one or more of any suitable organic polar solvent, preferably organic polar solvents that includes amides, sulfones, sulfoxides, saturated alcohols and the like. Such organic polar solvents include, but are not limited to, organic polar solvents such as sulfolane (tetrahydrothlopene-1,1-dioxide), 3-methylsulfolane, n-propyl sulfone, dimethyl sulfoxide (DMSO), methyl sulfone, n-butyl sulfone, 3-methylsulfolane, amides such as 1-(2-hydroxyethyl) -2-pyrrolidone (HEP), dimethylpiperidone (DMPD), N-methyl-2-pyrrolidone (NMP), dimethylacetamide (DMAc), and dimethylformamide (DMF), glycols and glycol ethers, and mixtures thereof. Especially preferred as the organic polar solvent are N-methyl pyrrolidone, sulfolane, DMSO, diethylene glycol ethyl ether (carbitol), ethylene glycol, methoxy propanol and mixtures of two or more of these solvents.

The di or polyamine component is selected from (2-aminoethyl)-2-aminoethanol, diethylene triamine and triethylene tetramine. Especially preferred is (2-aminoethyl)-2-aminoethanol.

The corrosion inhibiting component may be any 8-hydroxyquinoline and isomers thereof, or catechol. Especially preferred corrosion inhibitors include 8-hydroxyquinoline and catechol.

The compositions of this invention may also optionally contain one or more of any suitable organic hydroxyl- or polyhydroxyl-containing aliphatic compounds as a co-solvent. Any suitable organic hydroxyl-containing co-solvent may be employed in the compositions of this invention. Examples of such suitable organic hydroxyl-containting co-solvents include, but are not limited to, glycerol, 1,4-butane diol, 1,2-cyclopantanediol, 1,2-cydohexanediol, and methylpentanediol, and saturated alcohols such as ethanol, propanol, butanol, hexanol, and hexafluoroisopropanol, and mixtures thereof. A co-solvent may be present in the compositions of this invention in an amount, based on the total weight of the composition, of from 0 to 10 wt%, preferably from 0.1 to 10 wt%, most preferably from 0.5 to 5 wt%, based on the weight of the composition.

The compositions of this invention may also contain one or more of any suitable other corrosion-inhibiting agents, preferably aryl compounds containing two or more OH, OR₆, and/or SO₂R₆R₇ groups bonded directly to the aromatic ring, where R₆, R₇ and R₈ are each independently alkyl, preferably alkyl of from 1 to 6 carbon atoms, or aryl, preferably aryl of from 6 to 14 carbon atoms. As examples of such preferred corrosion-inhibiting agents there may be mentioned pyrogallol, gallic acid and resorcinol. Such other corrosion-inhibiting agents may be present in an amount of from 0 to 10 wt%, preferably from 0.1 to 10 wt%, most preferably from 0.5 to 5 wt% based on the weight of the composition.

Organic or inorganic chelating or metal complexing agents are not required, but offer substantial benefits, such as for example, improved product stability. One or more of such inorganic chelating or metal complexing agents may be employed in the compositions of this invention. Examples of suitable chelating or complexing agents include but are not limited to trans-1,2-cyclohexanediamine tetraacetic add (CyDTA), ethylenediamine tetraacetic add (EDTA), stannates, pyrophosphates, alkylidene-diphosphonic add derivatives (e.g. ethane-1-hydroxy-1,1-diphosphonate), phosphonates containing ethylenediamine, diethylenetriamine or triethylenetetramine functional moieties e.g., ethylenediamine tetra(methytene phosphonic acid) (EDTMP), diethylenetriamine penta(methylene phosphonic acid), and triethylenetetramine hexa(methylene phosphonic acid), and mixtures thereof. The chelating agent will be present in the composition in an amount of from 0 to 5 wt%, preferably from 0.1 to 2 wt%, based on the weight of the composition. Metal chelating or complexing agents of various phosphonates, such as ethylenediamine tetra(methylene phosphonic add) (EDTMP) offer much improved stabilization of the cleaning compositions of the cleaning compositions of this invention containing oxidizing agents at acidic and alkaline conditions and thus are generally preferred.

The cleaning compositions optionally may also contain one or more suitable surfactants, such as for example dimethyl hexynol (Surfynol-61), ethoxylated tetramethyl decynediol (Surfynol-465), polytetrafluoroethylene cetoxypropylbetaine (Zonyl FSK) and Zonyl FSH. The surfactant will generally be present in an amount of from 0 to 5 wt%, preferably 0.1 to 3 wt%, based on the weight of the composition.

Example of cleaning compositions of this invention include, but are not limited to, the compositions set forth in the following Tables 1 to 3. In Tables 1 to 3 the abbreviations employed are as follows:
- NMP=: N-methyl pyrrolidinone
- SFL=: sulfolane
- DMSO=: dimethyl sulfoxide
- CARB=: carbitol
- EG=: ethylene glycol
- GE: =methoxy propanol (Glycol ether PM)
- AEEA=: (2-amionoethyl)-2-aminothanol
- CAT=: catechol
- 8HQ=: 8-hydroxyquinoline

**Table 1**

| | **Compositions/Parts by Weight** | | | | |
|---|---|---|---|---|---|
| **Components** | **1** | **2** | **3** | **4** | **5** |
| NMP | 60 | 60 | | | |
| SFL | 15 | 15 | | | |
| DMSO | 15 | 15 | | | |
| CARB | | | 87 | 77 | 89 |
| EG | | | | | 1 |
| GE | | | | | |
| AEEA | 9 | 9 | 10 | 20 | 10 |
| CAT | | 1 | 3 | 3 | |
| 8HQ | 1 | | | | 1 |

**Table 2**

| | **Compositions/Parts by Weight** | | | | |
|---|---|---|---|---|---|
| **Components** | **6** | **7** | **8** | **9** | **10** |
| NMP | | | 24 | | 30 |
| SFL | | | | | |
| DMSO | | | | 24 | |
| CARB | 84 | 60 | 60 | 60 | 60 |
| EG | | 24 | | | |
| GE | | | | | |
| AEEA | 15 | 15 | 15 | 15 | 9 |
| CAT | | | | 1 | |
| 8HQ | 1 | 1 | 1 | | 1 |

**Table 3**

| | **Compositions/Parts by Weight** | | |
|---|---|---|---|
| **Components** | **11** | **12** | **13** |
| NMP | | | 30 |
| SFL | | | 20 |
| DMSO | 30 | | |
| CARB | 60 | | |
| EG | | | |
| GE | | 84 | 40 |
| AEEA | 9 | 15 | 9 |
| CAT | | | |
| 8HQ | 1 | 1 | 1 |

The galvanic anti-corrosion inhibiting results obtained with the cleaning compositions of this invention is illustrated by the following test. Microelectronic substrates with a triple-layer metal feature (Mo/Al/Mo) and coated with photoresist were treated in Composition No. 6 of Table 1 and also in a comparative composition where the AEEA component was replaced with 15 % monoethanolamine, i.e., a comparative composition of 84% carbitol, 15% ethanolamine and 1% 8-hydroxyquinoline. The substrates were first placed in the compositions for 5 minutes at 70 °C, then removed and observed, and then the substrates were immersed in 5% diluted solutions of the respective compositions (i.e., dilutions of 5g of the composition in 95 g water) for 5 minutes at room temperature to simulate a conventional washing step in the processing of the substrates. After this second treatment, the substrates with the triple-layer features were removed from the diluted solutions, rinsed with water and observed by pictures take with a SEM. The aluminum corrosion results after each step were as follows:
Composition 6

| | |
|---|---|
| After treatment in Composition 6 | no Al corrosion |
| After treatment in 5% solution | slight Al corrosion |

Comparative Composition

| | |
|---|---|
| After treatment in Comparative Composition | no Al corrosion |
| After treatment in 5% solution | severe Al corrosion |

Similar corrosion inhibiting with respect to such tripe-layer metal feature substrates were also observed when Compositions 8 to 13 of Table 2 and 3 were subjected to the same testing regimen in both the Composition formulation and in 5% diluted solutions thereof and observed under an SEM.

## Claims

1. A non-aqueous cleaning composition for cleaning photoresist and residues from a microelectronic substrate **characterized by** a stacked layer structure of different types of metals at a surface on the microelectronic substrate, said cleaning composition comprising:
(a) from 50 to 90% by weight of the composition of at least one polar organic solvent,
(b) from 5% to 20% by weight of the composition of at least one di or polyamine selected from the group consisting of (2-aminoethyl)-2-aminoethanol, diethylene triamine and triethylene tetramine, and
(c) from 0.1% to 10% by weight of the composition of at least one corrosion inhibitor that is selected from the group consisting of 8-hydroxyquinoline and isomers thereof and catechol.

2. A cleaning composition of claim 1 wherein the polar organic solvent component (a) comprises from 85 to 90% by weight of the composition, the di- or polyamine component (b) comprises from 5% to 15% by weight of the composition and the corrosion inhibiting component (c) is present in the composition in an amount of from 0.3% to 3% by weight of the composition.

3. A cleaning composition of claim 1 wherein the polar organic solvent component (a) is selected from the group consisting of sulfolane, dimethyl sulfoxide, N-methyl-2-pyrrolidone, carbitol, ethylene glycol and methoxy propanol and mixtures thereof, the di- or polyamine component (b) is selected from the group consisting of 2-aminoethyl-2-aminoethanol, diethylene triamine, and triethylene tetramine, and the corrosion inhibiting component (c) is selected from 8-hydroxyquinoline and catechol.

4. A cleaning composition of claim 2 wherein the polar organic solvent component (a) is selected from the group consisting of sulfolane, dimethyl sulfoxide, N-methyl-2-pyrrolidone, carbitol, ethylene glycol, and methoxy propanol and mixtures thereof, the di- or polyamine component (b) is selected from the group consisting of (2-aminoethyl)-2-aminoethanol, diethylene triamine, and triethylene tetramine, and the corrosion inhibiting component (c) is selected from 8-hydroxyquinoline and catechol.

5. A cleaning composition of claim 1 wherein the di- or polyamine component (b) is (2-aminoethyl)-2-aminoethanol.

6. A cleaning composition of claim 4 wherein the di- or polyamine component (b) is (2-aminoethyl)-2-aminoethanol.

7. A cleaning composition of claim 6 comprising carbitol as polar organic solvent component (a) and 8-hydroxyquinoline as corrosion inhibiting component (c).

8. A process for cleaning photoresist or residue from a layered structured microelectronic device layered with different metals, the process comprising contacting the layered microelectronic device with a cleaning composition for a time sufficient to clean the photoresist or residue from the device, wherein the cleaning composition comprises a non-aqueous composition of:
(a) from 50 to 90% by weight of the composition at least one polar organic solvent,
(b) from 5% to 20% by weight of the composition of at least one di or polyamine selected from the group consisting of (2-aminoethyl)-2-aminoethanol, diethylene triamine or triethylene tetramine, and
(c) from 0.1% to 10% by weight of the composition at least one corrosion inhibitor that is selected from the group consisting of 8-hydroxyquinoline and isomers thereof and catechol.

9. A process according to claim 8 wherein the polar organic solvent component (a) comprises from 85 to 90% by weight of the composition, the di- or polyamine component (b) comprises from 5% to 15% by weight of the composition and the corrosion inhibiting component (c) is present in the composition in an amount of from 0.3% to 3% by weight of the composition.

10. A process according to claim 8, wherein the polar organic solvent component (a) is selected from the group consisting of sulfolane, dimethyl sulfoxide, N-methyl-2-pyrrolidone, carbitol, ethylene glycol and methoxy propanol and mixtures thereof, the di- or polyamine component (b) is selected from the group consisting of 2-aminoethyl-2-aminoethanol, diethylene triamine, and triethylene tetramine, and the corrosion inhibiting component (c) is selected from 8-hydroxyquinoline and catechol.

11. A process according to claim 9 wherein the polar organic solvent component (a) is selected from the group consisting of sulfolane, dimethyl sulfoxide, N-methyl-2-pyrrolidone, carbitol, ethylene glycol, and methoxy propanol and mixtures thereof, the di- or polyamine component (b) is selected from the group consisting of (2-aminoethyl)-2-aminoethanol, diethylene triamine, and triethylene tetramine, and the corrosion inhibiting component (c) is selected from 8-hydroxyquinoline and catechol.

12. A process according to claim 8, wherein the di- or polyamine component (b) is (2-aminoethyl)-2-aminoethanol.

13. A process according to claim 11, wherein the di- or polyamine component (b) is (2-aminoethyl)-2-aminoethanol.

14. A process according to claim 13 comprising carbitol as polar organic solvent component (a) and 8-hydroxyquinoline as corrosion inhibiting component (c).

## Patentansprüche

1. Nicht-wässrige Reinigungszusammensetzung für das Entfernen von Fotolack und Ablagerungen von einem Mikroelektroniksubstrat, das durch eine Stapelschichtstruktur verschiedener Metallarten an einer Oberfläche am Mikroelek-troniksubstrat **gekennzeichnet** ist, wobei in der Reinigungszusammensetzung:
(a) 50 bis 90 Gew.-% der Zusammensetzung mindestens ein polares organisches Lösungsmittel sind,
(b) 5 bis 20 Gew.-% der Zusammensetzung mindestens ein Di- oder Polyamin, ausgewählt aus der Gruppe, die aus (2-Aminoethyl)-2-Aminoethanol, Diethylentriamin und Triethylentetramin besteht, sind, und
(c) 0,1 bis 10 Gew.-% der Zusammensetzung mindestens ein Korrosionshemmer, der ausgewählt aus der Gruppe ist, die aus 8-Hydroxychinolin und Isomeren davon und Catechol besteht, sind.

2. Reinigungszusammensetzung nach Anspruch 1, in der die polare organische Lösungsmittelkomponente (a) 85 bis 90 Gew.-% der Zusammensetzung ist, die Di- oder Polyaminkomponente (b) 5 bis 15 Gew.-% der Zusammensetzung ist und die Korrosionshemmerkomponente (c) in der Zusammensetzung in der Menge von 0,3 bis 3 Gew.-% der Zusammensetzung vorhanden ist.

3. Reinigungszusammensetzung nach Anspruch 1, in der die polare organische Lösungsmittelkomponente (a) ausgewählt ist aus der Gruppe, die aus Sulfolan, Dimethylsulfoxid, N-methyl-2-pyrrolidon, Carbitol, Ethylenglycol und Methoxypropanol und Gemischen daraus besteht, die Di- oder Polyaminkomponente (b) ausgewählt ist aus der Gruppe, die aus 2-Aminoethyl-2-Aminoethanol, Diethylentriamin und Triethylentetramin besteht und die Korrosionshemmerkomponente (c) aus 8-Hydroxychinolin und Catechol ausgewählt ist.

4. Reinigungszusammensetzung nach Anspruch 2, in der die polare organische Lösungsmittelkomponente (a) ausgewählt ist aus der Gruppe, die aus Sulfolan, Dimethylsulfoxid, N-methyl-2-pyrrolidon, Carbitol, Ethylenglycol und Methoxypropanol und Gemischen daraus besteht, die Di- oder Polyaminkomponente (b) ausgewählt ist aus der Gruppe, die aus (2-Aminoethyl)-2-Aminoethanol, Diethylentriamin und Triethylentetramin besteht und die Korrosionshemmerkomponente (c) ausgewählt ist aus 8-Hydroxychinolin und Catechol.

5. Reinigungszusammensetzung nach Anspruch 1, in der die Di- oder Polyaminkomponente (b) (2-Aminoethyl)-2-Aminoethanol ist.

6. Reinigungszusammensetzung nach Anspruch 4, in der die Di- oder Polyaminkomponente (b) (2-Aminoethyl)-2-Aminoethanol ist.

7. Reinigungszusammensetzung nach Anspruch 6, die Carbitol als polare organische Lösungsmittelkomponente (a) und 8-Hydroxychinolin als Korrosionshemmerkomponente (c) enthält.

8. Verfahren zum Entfernen von Fotolack oder Ablagerungen von einer mit verschiedenen Metallen geschichteten Mikroelektronikvorrichtung, die in Schichten strukturiert ist, wobei das Verfahren das Kontaktieren der geschichteten Mikroelektronikvorrichtung mit einer Reinigungszusammensetzung für eine Zeit umfasst, die ausreicht, um den Fotolack oder die Ablagerung von der Vorrichtung zu entfernen, wobei die Reinigungszusammensetzung eine nicht-wässrige Zusammensetzung ist, in der:
(a) 50 bis 90 Gew.-% der Zusammensetzung mindestens ein polares organisches Lösungsmittel sind,
(b) 5 bis 20 Gew.-% der Zusammensetzung mindestens ein Di- oder Polyamin, ausgewählt aus der Gruppe, die aus (2-Aminoethyl)-2-Aminoethanol, Diethylentriamin und Triethylentetramin besteht, sind, und
(c) 0,1 bis 10 Gew.-% der Zusammensetzung mindestens ein Korrosionshemmer, der ausgewählt aus der Gruppe ist, die aus 8-Hydroxychinolin und Isomeren davon und Catechol besteht, sind.

9. Verfahren gemäß Anspruch 8, bei dem die polare organische Lösungsmittelkomponente (a) 85 bis 90 Gew.-% der Zusammensetzung ist, die Di- oder Polyaminkomponente (b) 5 bis 15 Gew.-% der Zusammensetzung ist und die Korrosionshemmerkomponente (c) in der Zusammensetzung in einer Menge von 0,3 bis 3 Gew.-% der Zusammensetzung vorhanden ist.

10. Verfahren gemäß Anspruch 8, in dem die polare organische Lösungsmittelkomponente (a) aus der Gruppe ausgewählt ist, die aus Sulfolan, Dimethyl-sulfoxid, N-methyl-2-pyrrolidon, Carbitol, Ethylenglycol und Methoxypropanol und Gemischen daraus besteht, die Di- oder Polyaminkomponente (b) aus der Gruppe ausgewählt ist, die aus 2-Aminoethyl-2-Aminoethanol, Diethylentriamin und Triethylentetramin besteht und die Korrosionshemmerkomponente (c) ausgewählt ist aus 8-Hydroxychinolin und Catechol.

11. Verfahren nach Anspruch 9, in dem die polare organische Lösungsmittelkomponente (a) ausgewählt ist aus der Gruppe, die aus Sulfolan, Dimethylsulf-oxid, N-methyl-2-pyrrolidon, Carbitol, Ethylenglycol und Methoxypropanol und Gemischen daraus besteht, die Di- oder Polyaminkomponente (b) ausgewählt ist aus der Gruppe, die aus (2-Aminoethyl)-2-Aminoethanol, Diethylentriamin und Triethylentetramin besteht und die Korrosionshemmerkomponente (c) ausgewählt ist aus 8-Hydroxychinolin und Catechol.

12. Verfahren gemäß Anspruch 8, in dem die Di- oder Polyaminkomponente (b) (2-Aminoethyl)-2-Aminoethanol ist.

13. Verfahren gemäß Anspruch 11, in dem die Di- oder Polyaminkomponente (b) (2-Aminoethyl)-2-Aminoethanol ist.

14. Verfahren nach Anspruch 13, das Carbitol als polare organische Lösungsmittelkomponente (a) und 8-Hydroxychinolin als Korrosionshemmerkomponente (c) enthält.

## Revendications

1. Composition non aqueuse de nettoyage pour éliminer une réserve photosensible et des résidus d'un substrat de microélectronique **caractérisé par** une structure composée de différents types de métaux en couches superposées au niveau d'une surface sur le substrat de microélectronique, ladite composition de nettoyage contenant :
(a) 50% à 90% en poids de la composition d'au moins un solvant organique polaire,
(b) 5% à 20% en poids de la composition d'au moins une di- ou poly-amine choisie dans le groupe constitué par le (2-aminoéthyl)-2-aminoéthanol, la diéthylène triamine et la triéthylène tétramine, et
(c) 0,1% à 10% en poids de la composition d'au moins un inhibiteur de corrosion qui est choisi dans le groupe constitué par la 8-hydroxyquinoline et ses isomères et le catéchol.

2. Composition de nettoyage selon la revendication 1, dans laquelle le composant solvant organique polaire (a) comprend 85% à 90% en poids de la composition, le composant di- ou poly-amine (b) comprend 5% à 15% en poids de la composition et le composant inhibant la corrosion (c) est présent dans la composition en une quantité allant de 0,3% à 3% en poids de la composition.

3. Composition de nettoyage selon la revendication 1, dans laquelle le composant solvant organique polaire (a) est choisi dans le groupe constitué par le sulfolane, le diméthylsulfoxyde, la N-méthyl-2-pyrrolidone, le carbitol, l'éthylène glycol et le méthoxy propanol et leurs mélanges, le composant di- ou poly-amine (b) est choisi dans le groupe constitué par le 2-aminoéthyl-2-aminoéthanol, la diéthylène triamine et la triéthylène tétramine et le composant inhibant la corrosion (c) est choisi parmi la 8-hydroxyquinoline et le catéchol.

4. Composition de nettoyage selon la revendication 2, dans laquelle le composant solvant organique polaire (a) est choisi dans le groupe constitué par le sulfolane, le diméthylsulfoxyde, la N-méthyl-2-pyrrolidone, le carbitol, l'éthylène glycol et le méthoxy propanol et leurs mélanges, le composant di- ou poly-amine (b) est choisi dans le groupe constitué par le (2-aminoéthyl)-2-aminoéthanol, la diéthylène triamine et la triéthylène tétramine et le composant inhibant la corrosion (c) est choisi parmi la 8-hydroxyquinoline et le catéchol.

5. Composition de nettoyage selon la revendication 1, dans laquelle le composant di- ou poly-amine (b) est le (2-aminoéthyl)-2-aminoéthanol.

6. Composition de nettoyage selon la revendication 4, dans laquelle le composant di- ou poly-amine (b) est le (2-aminoéthyl)-2-aminoéthanol.

7. Composition de nettoyage selon la revendication 6, comprenant du carbitol en tant que composant solvant organique polaire (a) et de la 8-hydroxyquinoline en tant que composant inhibant la corrosion (c).

8. Procédé d'élimination d'une réserve photosensible ou d'un résidu d'un dispositif microélectronique à structure en couches constituées de métaux différents, le procédé comprenant le contact du dispositif microélectronique en couches avec une composition de nettoyage pendant une durée suffisante pour éliminer du dispositif la réserve photosensible ou le résidu, dans lequel la composition de nettoyage comprend une composition non aqueuse contenant :
(a) 50% à 90% en poids de la composition d'au moins un solvant organique polaire,
(b) 5% à 20% en poids de la composition d'au moins une di- ou poly-amine choisie dans le groupe constitué par le (2-aminoéthyl)-2-aminoéthanol, la diéthylène triamine et la triéthylène tétramine, et
(c) 0,1% à 10% en poids de la composition d'au moins un inhibiteur de corrosion qui est choisi dans le groupe constitué par la 8-hydroxyquinoline et ses isomères et le catéchol.

9. Procédé selon la revendication 8, dans lequel le composant solvant organique polaire (a) comprend 85% à 90% en poids de la composition, le composant di- ou poly-amine (b) comprend 5% à 15% en poids de la composition et le composant inhibant la corrosion (c) est présent dans la composition en une quantité allant de 0,3% à 3% en poids de la composition.

10. Procédé selon la revendication 8, dans lequel le composant solvant organique polaire (a) est choisi dans le groupe constitué par le sulfolane, le diméthylsulfoxyde, la N-méthyl-2-pyrrolidone, le carbitol, l'éthylène glycol et le méthoxy propanol et leurs mélanges, le composant di- ou poly-amine (b) est choisi dans le groupe constitué par le 2-aminoéthyl-2-aminoéthanol, la diéthylène triamine et la triéthylène tétramine et le composant inhibant la corrosion (c) est choisi parmi la 8-hydroxyquinoline et le catéchol.

11. Procédé selon la revendication 9, dans lequel le composant solvant organique polaire (a) est choisi dans le groupe constitué par le sulfolane, le diméthylsulfoxyde, la N-méthyl-2-pyrrolidone, le carbitol, l'éthylène glycol et le méthoxy propanol et leurs mélanges, le composant di- ou poly-amine (b) est choisi dans le groupe constitué par le (2-aminoéthyl)-2-aminoéthanol, la diéthylène triamine et la triéthylène tétramine et le composant inhibant la corrosion (c) est choisi parmi la 8-hydroxyquinoline et le catéchol.

12. Procédé selon la revendication 8, dans lequel le composant di- ou poly-amine (b) est le (2-aminoéthyl)-2-aminoéthanol.

13. Procédé selon la revendication 11, dans lequel le composant di- ou poly-amine (b) est le (2-aminoéthyl)-2-aminoéthanol.

14. Procédé selon la revendication 13, comprenant du carbitol en tant que composant solvant organique polaire (a) et de la 8-hydroxyquinoline en tant que composant inhibant la corrosion (c).
